# EUROPÄISCHE PATENTSCHRIFT

(11) **EP 0 842 594 B1**
(45) Veröffentlichungstag und Bekanntmachung des Hinweises auf die Patenterteilung: **31.03.1999**
(21) Anmeldenummer: 96921898.1
(22) Anmeldetag: 06.07.1996
(51) Int. Cl.: H05K 7/20

(54) **STEUERGERÄT BESTEHEND AUS MINDESTENS ZWEI GEHÄUSETEILEN**
CONTROLLER WITH A HOUSING MADE OF AT LEAST TWO PARTS
APPAREIL DE COMMANDE AVEC UN BOITIER CONSTITUE D'AU MOINS DEUX PARTIES

(30) Priorität: 04.08.1995 DE 19528632
(43) Veröffentlichungstag der Anmeldung: 20.05.1998
(73) Patentinhaber: ROBERT BOSCH GMBH, 70442 Stuttgart (DE)
(72) Erfinder: CUNTZ, Harald, D-71296 Heimsheim (DE); JARES, Peter, D-71069 Sindelfingen (DE); KARR, Dieter, D-75233 Tiefenbronn (DE)
(86) Internationale Anmeldenummer: DE9601212
(87) Internationale Veröffentlichungsnummer: WO9706658

(56) Entgegenhaltungen:
- DE-A- 4 107 312
- DE-A- 4 222 838
- DE-A- 4 234 022

## Beschreibung

### Stand der Technik

Die Erfindung geht aus von einem Steuergerät bestehend aus mindestens zwei Gehäuseteilen nach der Gattung des Hauptanspruchs. Bei einem zum Beispiel aus dem DE-Gbm 92 00 624.8 (DE 4218112) bekannten Steuergerät wird eine Leiterplatte zwischen zwei Gehäuseteilen, d.h. einem Gehäusedeckel und einem Gehäuseboden mit Hilfe von Verschraubungen fest eingesetzt. Der Gehäusedeckel und der Gehäuseboden sind aus gut wärmeleitendem Material hergestellt. Um die Verlustwärme der auf der Leiterplatte angeordneten Leistungsbauelemente über die Gehäuseteile abführen zu können, ist die Leiterplatte mit einer wärmeleitenden schicht, zum Beispiel einer Kupferkaschierung, einer Zinnschicht oder einer wärmeleitenden Paste versehen. Insbesondere neuartige Leistungsbauelemente haben aber eine so hohe Verlustleistung, die mit Hilfe der herkömmlichen wärmeleitenden schicht und des bisherigen konstruktiven Aufbaus nur sehr schwer nach außen abgeleitet werden können. Bei anderen steuergerätekonzepten wird zur Wärmeableitung die Unterseite des die Leistungsbauelemente tragenden substrats vollständig mit einer wärmeableitenden schicht versehen. Dadurch kann diese seite der Leiterplatte nicht mehr mit Leistungsbauelementen bestückt werden, wodurch sich ein Flächenmehrbedarf und somit eine hohe Kostenentwicklung ergibt.

### Vorteile der Erfindung

Das erfindungsgemäße Steuergerät mit den kennzeichnenden Merkmalen des Hauptanspruchs hat demgegenüber den Vorteil, daß aufgrund der erfindungsgemäßen Kombination eines neuartigen Klebers und des konstruktiven Aufbaus eine relativ hohe Verlustwärme abgeleitet werden kann. Bis auf den Auflagebereich der Leiterplatte auf dem einen Gehäuseteil kann die Leiterplatte in einfacher Weise auf beiden seiten mit Bauelementen bestückt werden. Als Leiterplatten können weiterhin standardplatinen verwendet werden. Der Kleber selbst wird nur auf einem Gehäuseteil aufgebracht, so daß der herkömmliche Fertigungsprozeß nur geringfügig abgeändert werden muß. Bereits nach dem Aufbringen des Klebers, d.h. vor seiner Aushärtung, hat der Kleber eine so hohe Haftfähigkeit, daß er das eine Gehäuseteil und die Leiterplatte fixiert bzw. die Teile miteinander justiert werden können. Durch die Kombination des neuartigen Klebers und der Abänderung der Konstruktion eines Gehäuseteils wird die Wärmeableitung gegenüber den bisher bekannten systemen nahezu verdoppelt. Dadurch kann die Leiterplatte auch mit Leistungsbauelementen mit sehr hoher Verlustwärme und somit hoher Leistungsdichte bestückt werden. Auch wird eine elektrische Isolation von der Leiterplatte zu den Gehäuseteilen hin gewährleistet. Durch die beidseitige Bestückung der Leiterplatte mit Bauelementen ist eine optimale Flächenausnutzung und eine Kostenminimierung möglich.

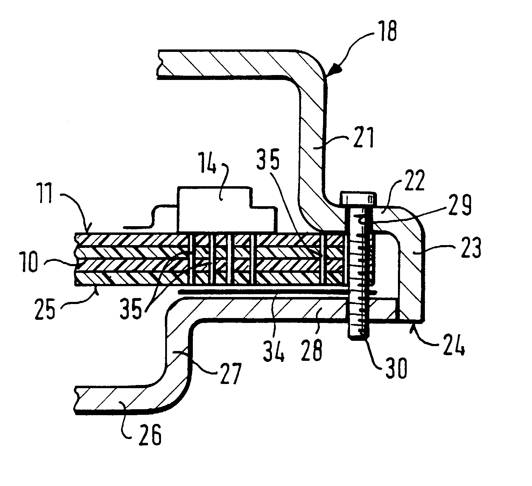

Weitere Vorteile und vorteilhafte Weiterbildungen ergeben sich aus der Beschreibung und der Zeichnung.

### Zeichnung

Ein Ausführungsbeispiel der Erfindung ist in der Zeichnung dargestellt und in der nachfolgenden Beschreibung näher erläutert. Die einzige Figur zeigt einen schnitt durch eine schematische Darstellung eines Teils eines steuergeräts.

### Beschreibung des Ausführungsbeispiels

Das elektrische Schalt- oder Steuergerät hat eine Leiterplatte 10, auf deren Oberseite 11 eine elektronische schaltung aufgebracht ist, von der nur ein elektronisches Bauelement 14, das Verlustwärme bei Betrieb abgibt, dargestellt ist. In der Zeichnung ist dieses als SMD-Bauelement (Surface Mounted Device) ausgeführt. In nicht dargestellter Weise ist die Leiterplatte 10 in herkömmlicher Weise mit einer steckerleiste verbunden.

Die Oberseite 11 der Leiterplatte 10 wird von einem wannenförmigen Gehäusedeckel 18 abgedeckt. Bis auf den Bereich der steckerleiste hat der Gehäusedeckel an seinen Seitenwänden 21 einen durchgehenden, kragenförmigen Rand 22, der auf dem äußeren Bereich der Leiterplatte 10 aufliegt. Die Leiterplatte 10 ist dazu im Bereich ihrer Außenränder frei von schaltungsbauteilen und Leiterbahnen.

Der durchgehende Rand 22 hat eine parallel zu den jeweiligen Seitenwänden 21 verlaufende, abgewinkelte Kante 23, die die stirnseiten der Leiterplatte 10 umfaßt. Diese abgewinkelte Kante 23 kann an ihrer Unterseite 24 bündig mit der Unterseite 25 der Leiterplatte 10 abschließen oder wie in der Zeichnung dargestellt, über die Leiterplatte 10 hinausragen.

Die Unterseite 25 der Leiterplatte 10 wird von einem ebenfalls wannenförmigen Gehäuseboden 26 umfaßt, dessen Seitenwände 27 einen durchgehenden, kragenförmigen Rand 28 haben, der auf dem äußeren Bereich der Unterseite 25 der Leiterplatte 10 anliegt. Der Rand 28 schließt hierbei mit der Kante 23 des Gehäusedeckels 18 bündig ab, so daß die Leiterplatte 10 zwischen dem Gehäusedeckel 18 und dem Gehäuseboden 26 eingeschlossen ist. Die Ränder 22, 28 des Gehäusedeckels 18 und des Gehäusebodens 26 haben mehrere fluchtende Bohrungen 29, die auch die Leiterplatte 10 durchdringen, und in die schrauben 30 eingesetzt sind, die den Gehäusedeckel 18, die Leiterplatte 10 und den Gehäuseboden 26 fest miteinander verbinden. Anstelle der Verschraubung vom Gehäusedeckel 18, Leiterplatte 10 und Gehäuseboden 26 können diese auch durch Kleben, Löten, Bördeln, Nieten, mittels Rastelementen oder anderen Verbindungstechniken fest miteinander verbunden sein. Der Gehäusedeckel 18 und der Gehäuseboden 26 sind vorzugsweise aus einem gut wärmeleitenden Material gefertigt. Erfindungsgemäß ist die Auflagefläche, d.h. der Rand 28 des Gehäusebodens 26 größer als die Auflagefläche, d.h. der Rand 22 des Gehäusedeckels 18 oder umgekehrt. Die Auflagefläche des Gehäusebodens auf der Leiterplatte, d.h. der Rand 28 ist hierbei so groß, daß auf der darüberliegenden seite der Leiterplatte 10 mindestens die Leistungsbauelemente 14 mit der größten Verlustwärme angeordnet werden können.

Würde man bei dem oben beschriebenen, bisher bekannten Steuergeräten nur die Auflagefläche, d.h. den Rand 28 des Gehäusebodens 26 vergrößern, und die bisher bekannten wärmeableitenden schichten auf der Unterseite der Leiterplatte 10 beibehalten, so könnte dies zu einer Verschlechterung der Ableitung der Verlustwärme von den Leistungsbauelementen nach außerhalb des Gehäuses führen. Ist die Leiterplatte 10 zwischen dem Gehäusedeckel 18 und dem Gehäuseboden 26 mit Hilfe der Verschraubung 30 fest eingeklemmt, so kann sich aufgrund der Verschraubung 30 zwischen dem Rand 28 und der Unterseite 25 der Leiterplatte 10 ein keilförmiger Spalt ausbilden. Dieser keilförmige Spalt wird ausgehend von der Verschraubung 30 zu den Seitenwänden 27 des Gehäusebodens 26 hin immer größer. Je größer dieser spalt ist, desto schlechter ist die Wärmeableitung zwischen dem Leistungsbauelement und den Gehäuseteilen 18 und 26. Dieser spalt kann erfindungsgemäß durch die Verwendung eines Füllstoffs mit thermisch gut leitenden und sowohl an der Unterseite 25 der Leiterplatte 10 und dem Rand 28 des Gehäusebodens 26 haftenden Füllstoffs 34 ausgeglichen werden. Wesentlich hierbei ist, daß dieser Füllstoff 34 so hohe haftende Eigenschaften aufweist, daß er beim Zusammenbau, d.h. wenn die Verschraubung 30 durchgeführt wird, sowohl an der Unterseite 25 der Leiterplatte 10, als auch am Rand 28 über die gesamte Länge des Randes 28, d.h. insbesondere seiner Auflagefläche haften bleibt, so daß die gute thermische Leitfähigkeit zwischen der Leiterplatte 10 und dem Gehäuseboden 26 bestehen bleibt. Um die Leitfähigkeit durch die Leiterplatte 10 hindurch zu verbessern sind in der Leiterplatte 10 insbesondere unterhalb des Leistungsbauelements 14 Durchkontaktierungen 35 ausgebildet, die auch in bekannter Weise mit wärmeleitenden Materialien ausgefüllt sein können.

Als Füllstoffe 34 können im Handel erhältliche Klebstoff-Filme mit wärmeleitfähigen Eigenschaften verwendet werden. Diese Filme sind sowohl elektrisch isolierend, als auch wärmeleitend. Diese Klebstoffe ermöglichen dann eine direkte Verklebung der Leiterplatte 10 auf dem Rand 28 des Gehäusebodens 26. Mit diesen Klebstoff-Filmen ist eine schnelle und einfache Verarbeitung bei Raumtemperatur möglich, wobei sich eine sofortige Verbindung der Oberflächen ergibt. Der Klebstoff-Film besitzt eine gute Anfangsklebkraft, um die beiden Bauteile bereits in ihrer Position zu halten. Anschließend muß der Kleber aushärten. Durch Druck und/oder Erwärmung kann die Endklebekraft schneller erreicht werden, da durch diese zusätzliche Maßnahme ein besseres Fließverhalten der Klebebänder erzielt wird.

Als Kleber eignet sich zum Beispiel die von der Firma 3M unter der Handelsbezeichnung Scotch™ 9882, 9885, 9890 vertriebenen Klebebänder.

Alternativ können auch sog. temperaturaushärtende Zweikomponentenklebesysteme eingesetzt werden. Hierbei handelt es sich um eine Mischung aus einem Härter und Silikonharz, die untereinander unter Temperaturerhöhung verbunden werden.

Verwendet man als Füllstoff 34 einen Kleber, so erhält man eine starre Verbindung zwischen der Leiterplatte 10 und dem Gehäuseboden 26. Es ist aber auch denkbar, als Füllstoff ein elastisches Material zu verwenden, das die oben beschriebenen Eigenschaften, d.h. die wärmeleitfähigen Eigenschaften und die haftenden Eigenschaften aufweist. Die elektrisch isolierenden Eigenschaften können zum Beispiel durch Einlegen von isolierenden schichten in die elastische Masse oder durch entsprechende Leiterplattenkonstruktion erreicht werden. Wird als Füllstoff 34, elastisches Material verwendet, so ist eine Bewegung entsprechend dem oben erwähnten Spalt möglich. Dabei wird aber ständig der thermisch leitfähige Kontakt zwischen der Leiterplatte 10 und dem Rand 28 des Gehäusebodens 26 aufrechterhalten.

Der Rand 28 des Gehäusebodens 26 kann als umlaufender Rand gleichmäßig an allen seiten des Gehäusebodens 26 ausgebildet sein. Er ist hierbei mindestens so groß, daß die Leistungsbauelemente 14 mit der höchsten Verlustwärme sich im Bereich des Rands 28 befinden können. Es ist aber auch möglich, den Rand 28 nur an einigen stellen, an denen sich die Leistungsbauelemente mit der sehr hohen Verlustwärme befinden, größer als die Auflagefläche des Gehäusedeckels auszubilden, so daß Inseln auf der Unterseite 25 der Leiterplatte 10 entstehen. In allen Fällen können herkömmlich bekannte Leiterplatten 10 verwendet werden.

## Patentansprüche

1. Steuergerät, bestehend aus mindestens zwei Gehäuseteilen (18, 26) und mindestens einem mit Leistungsbauelementen (14) bestückten Leiterplatte (10), wobei die Leiterplatte(n) (10) zwischen Gehäuseteilen (18, 26) am Randbereich eingespannt ist und die Leiterplatte (10) eine schicht (34) aus wärmeleitendem Material aufweist, dadurch gekennzeichnet, daß die Auflagefläche (28) eines ersten Gehäuseteils (26) auf der Leiterplatte (10) wenigstens im Bereich der am Rand der Leiterplatte (10) befindlichen Leistungsbauelemente (14) größer ist als die Auflagefläche (22) eines zweiten Gehäuseteils (18), daß die schicht (34) sich zwischen der Leiterplatte (10) und dem ersten Gehäuseteil (26) befindet und daß die schicht ein Füllstoff (34) mit thermisch gut leitenden und an der Leiterplatte (10) und dem ersten Gehäuseteil (26) haftenden Eigenschaften ist.

2. steuergerät nach Anspruch 1, dadurch gekennzeichnet, daß am Rand der Leiterplatte (10) im Bereich der Auflagefläche (28) des ersten Gehäuseteils (26) die Leistungsbauelemente (14) mit der größten Verlustwärme angeordnet sind.

3. Steuergerät nach Anspruch 1 und/oder 2, dadurch gekennzeichnet, daß der Füllstoff bei Druckbeaufschlagung aushärtet.

4. Steuergerät nach einem der Ansprüche 1 bis 3, dadurch gekennzeichnet, daß der Füllstoff (34) nach dem Aushärten elastische Eigenschaften hat.

5. Steuergerät nach Anspruch 1 und/oder 2, dadurch gekennzeichnet, daß der Füllstoff (34) aus zwei Komponenten besteht und bei Druckbeaufschlagung aushärtet.

6. Steuergerät nach Anspruch 1 und/oder 2, dadurch gekennzeichnet, daß der Füllstoff (34) aus zwei Komponenten besteht und bei Temperaturbeaufschlagung aushärtet.

7. Steuergerät nach einem der Ansprüche 1 bis 6, dadurch gekennzeichnet, daß das erste Gehäuseteil (26), die Leiterplatte (10) und das zweiten Gehäuseteil (18) fest miteinander verbunden sind.

## Claims

1. Controller, comprising at least two housing parts (18, 26) and at least one printed circuit board (10) fitted with power components (14), the printed circuit board(s) (10) being clamped between housing parts (18, 26) on the edge region and the printed circuit board (10) having a layer (34) made from thermally conducting material, characterized in that the bearing surface (28) of a first housing part (26) on the printed circuit board (10) is larger, at least in the region of the power components (14) located at the edge of the printed circuit board (10), than the bearing surface (22) of a second housing part (18), in that the layer (34) is located between the printed circuit board (10) and the first housing part (26), and in that the layer is a filler (34) with good thermal conduction properties and adhering to the printed circuit board (10) and the first housing part (26).

2. Controller according to Claim 1, characterized in that the power components (14) with the greatest heat loss are arranged at the edge of the printed circuit board (10) in the region of the bearing surface (28) of the first housing part (26).

3. Controller according to Claim 1 and/or 2, characterized in that the filler cures upon the application of pressure.

4. Controller according to one of Claims 1 to 3, characterized in that the filler (34) has elastic properties after curing.

5. Controller according to Claim 1 and/or 2, characterized in that the filler (34) consists of two components and cures upon the application of pressure.

6. Controller according to Claim 1 and/or 2, characterized in that the filler (34) consists of two components and cures upon the application of temperature.

7. Controller according to one of Claims 1 to 6, characterized in that the first housing part (26), the printed circuit board (10) and the second housing part (18) are permanently interconnected.

## Revendications

1. Appareil de commande, consistant en au moins deux parties de boîtier (18, 26) et en au moins une carte à circuits imprimés (10) garnie de composants de puissance (14), dans lequel la carte à circuits imprimés ou les cartes à circuits imprimés (10) est ou sont insérée(s) entre les parties du boîtier (18, 26) sur la zone de bordure et la carte à circuits imprimés (10) présente une couche (34) en une matière thermo-conductrice ,
caractérisé en ce que
- la surface d'appui (28) d'une première partie (26) du boîtier sur la carte à circuits imprimés (10) est plus grande au moins dans la zone des composants de puissance (14) qui se trouvent sur le bord de la carte à circuits imprimés (10) que la surface d'appui (22) d'une deuxième partie (18) du boîtier,
- la couche (34) se trouve entre la carte à circuits imprimés (10) et la première partie (26) du boîtier et
- la couche est une matière de remplissage (34) qui a de bonnes propriétés thermo-conductrices et adhère à la carte à circuits imprimés (10) et à la première partie (26) du boîtier.

2. Appareil de commande selon la revendication 1,
caractérisé en ce que
sur le bord de la carte à circuits imprimés (10) on dispose dans la zone de la surface d'appui (28) de la première partie (26) du boîtier les composants de puissance (14) qui dégagent les plus grandes pertes de chaleur.

3. Appareil de commande selon la revendication 1 et/ou 2,
caractérisé en ce que
la matière de remplissage est durcie en appliquant une pression.

4. Appareil de commande selon la revendication 1 à 3,
caractérisé en ce que
la matière plastique (34) a des propriétés élastiques après le durcissement.

5. Appareil de commande selon la revendication 1 et/ou 2,
caractérisé en ce que
la matière de remplissage (34) consiste en deux composants et durcit lors de l'application d'une pression.

6. Appareil de commande selon la revendication 1 et/ou 2,
caractérisé en ce que
la matière de remplissage (34) consiste en deux composants et durcit lors de l'application d'une chaleur.

7. Appareil de commande selon l'une des revendications 1 à 6,
caractérisé en ce que
la première partie (26) du boîtier, la carte à circuits imprimés (10) et la deuxième partie (18) du boîtier sont reliées de façon solidaire les unes aux autres.
